# DEMANDE DE BREVET EUROPEEN

(11) **EP 3 626 854 A1**
(43) Date de publication de la demande: **25.03.2020**
(21) Numéro de dépôt: 18195859.6
(22) Date de dépôt: 21.09.2018
(51) Int. Cl.: C23C 16/02, C23C 16/40, C23C 16/455, C23C 16/56, C23C 28/00, C25D 7/00, C25D 3/46, G04D 3/00, G04B 37/22, G04B 45/00

(54) **PROCEDE POUR AMELIORER L'ADHERENCE D'UNE COUCHE DE PROTECTION CONTRE LE TERNISSEMENT DE L'ARGENT SUR UN SUBSTRAT COMPRENANT UNE SURFACE ARGENTEE**

(71) Demandeur: The Swatch Group Research and Development Ltd, 2074 Marin (CH)
(72) Inventeur: Manasterski, Christian, 2525 Le Landeron (CH); Spassov, Vladislav, 1788 Praz (CH); Faure, Cédric, 2016 Cortaillod (CH)
(74) Mandataire: ICB SA

(57) **Abrégé**

L'invention se rapporte à un procédé pour améliorer l'adhérence d'une couche de protection contre le ternissement de l'argent sur un substrat comprenant une surface argentée finale, ledit procédé comprenant les étapes suivantes :
a) se munir d'un substrat (1) présentant ou non une surface argentée initiale
b) déposer sur ledit substrat (1) de l'étape a) une couche (2) d'un alliage d'argent et de cuivre comprenant entre 0.1% et 10% en poids de cuivre par rapport au poids total de l'alliage pour obtenir ladite surface argentée finale
c) déposer sur au moins une partie de ladite surface argentée finale obtenue à l'étape b) au moins une couche (4) de protection contre le ternissement de l'argent présentant une épaisseur comprise entre 1 nm et 200 nm.

## Description

### Domaine de l'invention

L'invention se rapporte à un procédé pour améliorer l'adhérence d'une couche de protection contre le ternissement de l'argent sur un substrat comprenant une surface argentée. Un tel substrat comprenant une surface argentée est notamment un élément horloger recouvert d'une fine couche d'argent.

### Arrière-plan de l'invention

Dans le domaine de l'horlogerie, il est usuel de réaliser un élément horloger en recouvrant un substrat d'une fine couche d'argent, déposée de préférence par la voie galvanique, afin de donner à l'élément horloger l'apparence très blanche et unique de l'argent. Un tel élément horloger est par exemple un cadran, en laiton ou en or, recouvert d'une fine couche d'argent.

Toutefois, l'argent présente l'inconvénient de ternir au cours du temps. Pour résoudre ce problème, il est connu de protéger la surface argentée sensible de l'élément horloger par la méthode de zaponnage. Le Zapon est un vernis cellulosique diluable dans un solvant. Le zaponnage est un procédé qui consiste à appliquer sur les surfaces à protéger plusieurs couches, par exemple par sprayage, de vernis Zapon, puis à les passer au four pour accélérer leur durcissement. Le revêtement final a une épaisseur totale d'environ 8 à 15 µm.

Cependant, ce vernis Zapon ne protège qu'imparfaitement les métaux sensibles. De plus, l'épaisseur nécessaire de vernis Zapon déposée gomme les détails fins de structuration, comme le guillochage fréquemment utilisé pour décorer un cadran. En conséquence, les détails du guillochage ne sont pas mis en valeur, et peuvent même disparaitre sous les couches de vernis. Enfin, les couches de vernis Zapon modifient la couleur et l'aspect de la surface argentée protégée en faisant varier le paramètre L* (de l'espace couleur CIE L*a*b*).

Afin de remplacer la méthode de zaponnage, il a été proposé de déposer une couche de protection sur la surface argentée sensible par un procédé ALD, tel que cela est décrit dans le brevet EP 1 994 202. Ce procédé permet de déposer un revêtement extrêmement fin (50 nm à 100 nm) et très protecteur, la protection obtenue étant supérieure à la protection obtenue avec un revêtement de 10 µm de Zapon.

Toutefois, ce procédé ALD présente le principal inconvénient de former, sur la surface argentée du substrat, une couche de protection présentant une faible adhérence à ladite surface argentée, de sorte que ladite couche de protection déposée par ALD se délamine à la moindre sollicitation, par exemple lors d'opérations de décoration finale par tampographie ou autre.

En outre, l'utilisation d'une couche de protection non adéquate déposée sur la surface argentée du substrat peut avoir pour inconvénient d'atténuer l'éclat et la couleur de l'argent et de modifier le rendu esthétique de la surface argentée.

### Résumé de l'invention

La présente invention a pour but de remédier à ces inconvénients en proposant un procédé permettant d'améliorer l'adhérence d'une couche de protection contre le ternissement de l'argent sur un substrat comprenant une surface argentée.

La présente invention a également pour but de proposer un procédé permettant d'obtenir un substrat présentant une surface argentée protégée efficacement contre le ternissement de l'argent tout en préservant l'aspect final de ladite surface argentée.

A cet effet, l'invention se rapporte à un procédé pour améliorer l'adhérence d'une couche de protection contre le ternissement de l'argent sur un substrat comprenant une surface argentée finale, caractérisé en ce qu'il comprend les étapes suivantes :
a) se munir d'un substrat présentant ou non une surface argentée initiale
b) déposer sur ledit substrat de l'étape a) une couche d'un alliage d'argent et de cuivre comprenant entre 0.1% et 10% en poids de cuivre par rapport au poids total de l'alliage pour obtenir ladite surface argentée finale
c) déposer sur au moins une partie de ladite surface argentée finale obtenue à l'étape b) au moins une couche de protection contre le ternissement de l'argent présentant une épaisseur comprise entre 1 nm et 200 nm, préférentiellement entre 40 nm et 100 nm.

La présente invention concerne également l'utilisation d'une couche d'un alliage d'argent et de cuivre comprenant entre 0.1% et 10% en poids de cuivre par rapport au poids total de l'alliage déposée sur un substrat présentant ou non une surface argentée initiale afin d'obtenir un substrat présentant une surface argentée finale, pour améliorer l'adhérence d'une couche de protection contre le ternissement de l'argent déposée sur ladite surface argentée finale, ladite couche de protection contre le ternissement de l'argent présentant une épaisseur comprise entre 1 nm et 200 nm, préférentiellement entre 40 nm et 100 nm.

L'utilisation d'une telle couche d'alliage d'argent et de cuivre déposée sur un substrat permet de créer des radicaux Cu en surface qui vont assurer l'adhérence de la couche de protection contre le ternissement de l'argent tout en préservant l'éclat argenté du substrat.

### Description sommaire des dessins

D'autres particularités et avantages ressortiront clairement de la description qui en est faite ci-après, à titre indicatif et nullement limitatif, en référence aux dessins annexés, dans lesquels :
- la figure 1 est une vue schématisée d'une première variante de substrat traité selon la présente invention; et
- la figure 2 est une vue schématisée d'une deuxième variante de substrat traité selon la présente invention.

### Description détaillée des modes de réalisation préférés

La présente invention concerne un procédé pour améliorer l'adhérence d'une couche de protection contre le ternissement de l'argent sur un substrat comprenant une surface argentée finale.

La première étape a) du procédé selon l'invention consiste à se munir d'un substrat 1 présentant ou non une surface argentée initiale.

Un tel substrat est par exemple un élément d'horlogerie ou de bijouterie, et notamment un élément horloger d'habillage. Notamment, le substrat peut être un cadran d'une pièce d'horlogerie, qui peut présenter à sa surface une structuration, telle qu'un guillochage, c'est-à-dire un ensemble de lignes avec de fins détails, qui se croisent en vue d'obtenir un effet décoratif. A cet effet, l'étape a) du procédé comprend une sous-étape selon laquelle on réalise sur la surface du substrat ladite structuration.

Le substrat 1 est de préférence métallique. Il peut être en laiton, à base d'or, jaune ou blanc, ou d'argent, ou tout autre métal ou alliage métallique, précieux ou non, approprié.

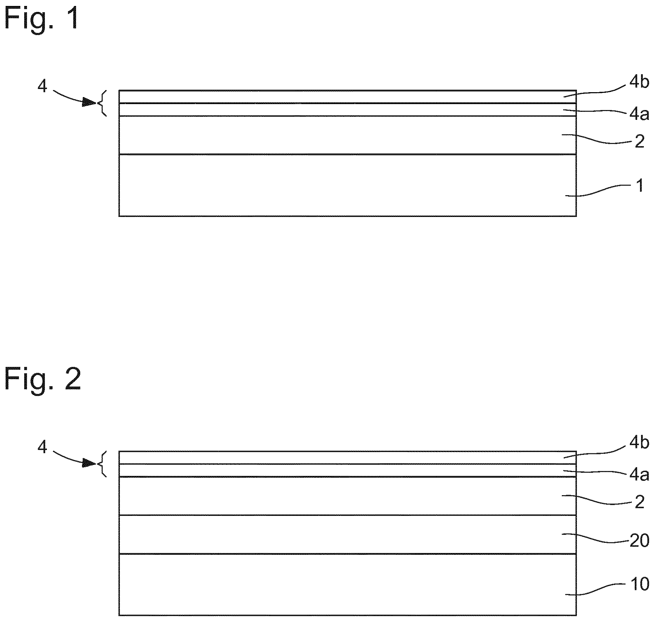

En référence à la figure 1, il est représenté un substrat 1 traité selon une première variante de l'invention selon laquelle le substrat 1 peut être sans surface argentée initiale ou comprendre une surface argentée intrinsèque. Dans le premier cas, le substrat peut être par exemple en laiton, à base d'or, jaune ou blanc, ou tout autre métal ou alliage métallique, précieux ou non, approprié à l'exception de l'argent. Dans le second cas, le substrat 1 est à base d'argent, en argent massif par exemple, et présente intrinsèquement une surface argentée initiale.

En référence à la figure 2, il est représenté un substrat 10 traité selon une deuxième variante de l'invention selon laquelle le substrat 10 n'est pas à base d'argent et comprend une surface argentée initiale obtenue par un dépôt, selon une sous-étape de l'étape a), d'une couche intermédiaire 20 d'argent sensiblement pur sur ledit substrat 10. Une telle couche 20 est de préférence déposée par voie galvanique. Le substrat 10 peut être lui-même en laiton et recouvert d'une couche de métal précieux, déposée par exemple par voie galvanique, par exemple une couche d'or. Le substrat 10 peut également être en métal précieux massif, par exemple en or massif.

Ladite couche 20 d'argent sensiblement pur peut présenter une épaisseur comprise entre 200 nm et 3 000 nm.

Selon un mode de réalisation, la couche 20 d'argent sensiblement pur présente une épaisseur comprise entre 200 nm et 600 nm, de préférence entre 300 nm et 500 nm afin de constituer un revêtement d'argent fin.

Selon un autre mode de réalisation, la couche 20 d'argent sensiblement pur présente une épaisseur comprise entre 1 000 nm et 3 000 nm, de préférence entre 1 500 nm et 2 500 nm afin de constituer un revêtement d'argent épais.

Un tel revêtement d'argent épais a pour avantage d'obtenir une couche intermédiaire d'argent sensiblement pur exempte de porosités, afin d'obtenir ensuite, comme on le verra ci-après, une couche d'argent et de cuivre selon l'étape b) sans porosité et d'assurer ainsi une adhésion accrue de la couche de protection contre le ternissement de l'argent sur ladite couche d'argent et de cuivre.

Conformément à l'invention, le substrat 1, 10 de l'étape a) est ensuite traité selon l'étape b) qui consiste à déposer sur ledit substrat 1, 10 de l'étape a) une couche 2 d'un alliage d'argent et de cuivre comprenant entre 0.1% et 10% en poids de cuivre par rapport au poids total de l'alliage pour obtenir un substrat 1, 10 présentant une surface argentée finale.

De préférence, la couche 2 d'alliage d'argent et de cuivre présente une épaisseur comprise entre 200 nm et 600 nm, plus préférentiellement entre 300 nm et 400 nm.

De préférence, l'alliage d'argent et de cuivre comprend entre 0.2% et 8% en poids, de préférence entre 0.5% et 7% en poids, de cuivre par rapport au poids total de l'alliage. La proportion de cuivre par rapport à l'argent est choisie de manière à créer suffisamment de radicaux Cu en surface qui vont ensuite assurer l'adhérence de la couche de protection contre le ternissement de l'argent, sans altérer la couleur de l'argent puisque la couche d'alliage d'argent et de cuivre forme la surface argentée finale du substrat.

La couche 2 d'alliage d'argent et de cuivre peut être déposée directement sur le substrat 1 comme représenté sur la figure 1 et se substituer au revêtement d'argent fin traditionnellement utilisé. La couche 2 d'alliage d'argent et de cuivre peut également être déposée sur la couche intermédiaire d'argent sensiblement pur 20 comme représenté sur la figure 2. La couche 2 d'alliage d'argent et de cuivre peut être déposée par tout procédé approprié, tel que PVD (dépôt flash), ou voie galvanique au moyen d'un bain galvanique d'argent et de cuivre approprié.

L'étape c) du procédé de l'invention consiste ensuite à déposer sur au moins une partie de la surface argentée finale obtenue à l'étape b) au moins une couche 4 de protection contre le ternissement de l'argent présentant une épaisseur comprise entre 1 nm et 200 nm, de préférence comprise entre 1 nm et 100 nm, et plus préférentiellement entre 40 nm et 100 nm.

L'étape c) peut être réalisée par une méthode choisie parmi le groupe comprenant un dépôt ALD (Atomic Layer Déposition), PVD (Physical Vapor Déposition), CVD (Chemical Vapor Déposition), et sol-gel. De préférence, l'étape c) est réalisée par dépôt ALD qui permet de former des couches compactes et d'obtenir des revêtements extrêmement fins et très protecteurs, avec un rendu esthétique particulièrement bon. Les détails et paramètres d'un tel dépôt ALD sont connus de l'homme du métier. Ils sont par exemple décrits dans le brevet EP 1 994 202. La couche Al₂O₃ peut être obtenue à partir d'un précurseur TMA (Tri-Méthyl-Aluminium) dont l'oxydation peut être réalisée avec H₂O, O₂ ; ou encore O₃. La couche TiO₂ peut être obtenue à partir de TTIP (Iso ProPoxyde de Titane) ou bien de TiCl₄ (Tri Chlorure de Titane) dont l'oxydation peut être réalisée par H2O, O₂ ou O₃.

Avantageusement, on utilise pour réaliser la couche de protection 4 contre le ternissement de l'argent déposée à l'étape c) un oxyde métallique, idéalement le plus transparent possible selon les épaisseurs souhaitées, choisi préférentiellement parmi Al₂O₃, Ta₂O₅, HfO₂, ZnO, SiO₂, et TiO₂. Des nitrures sont aussi possibles, comme par exemple le SiₓN_{y}. Un empilement de différentes couches est aussi possible.

De préférence, l'étape c) comprend une étape c1) de dépôt sur au moins une partie de ladite surface argentée finale obtenue à l'étape b) d'une première couche 4a de Al₂O₃ et une étape c2) de dépôt, sur la première couche 4a de Al₂O₃ obtenue à l'étape c1), d'une seconde couche 4b de TiO₂.

Avantageusement, la première couche 4a de Al₂O₃ présente une épaisseur comprise entre 0.5 nm et 100 nm, de préférence comprise entre 0.5 nm et 50 nm, et la seconde couche 4b de TiO₂ présente une épaisseur comprise entre 0.5 nm et 100 nm, de préférence comprise entre 0.5 nm et 50 nm.

Plus préférentiellement, la première couche 4a de Al₂O₃ présente une épaisseur comprise entre 30 nm et 50 nm et la seconde couche 4b de TiO₂ présente une épaisseur comprise entre 10 nm et 50 nm.

D'une manière particulièrement préférée, la couche 4 de protection contre le ternissement de l'argent est obtenue par un dépôt ALD d'une première couche d'Al₂O₃ présentant une épaisseur comprise entre 30 nm et 50 nm et d'une seconde couche 4b de TiO₂ présentant une épaisseur comprise entre 10 nm et 50 nm.

Une telle combinaison d'une première couche 4a de Al₂O₃ et d'une seconde couche 4b de TiO₂ présentant les épaisseurs indiquées ci-dessus permet de rehausser la couleur blanche de l'argent.

Avantageusement, le procédé de l'invention peut combiner dépôt de couches de protection et traitement plasma, avant et/ou après l'étape c2), typiquement un plasma Ar, afin de réduire les tensions internes des couches de protection déposées. Cette combinaison permet d'assouplir les couches de protection pour les rendre moins cassantes lors de sollicitations environnementales, telles que mécaniques, thermiques ou autres.

Avantageusement, le procédé de l'invention peut comprendre, entre l'étape b) et l'étape c), au moins une étape d) de prétraitement par plasma de la surface argentée finale du substrat obtenu à l'étape b).

Cette étape d) de prétraitement par plasma consiste à décaper la surface argentée finale du substrat afin d'éliminer notamment les sulfures AgS/Ag₂S qui se sont formés naturellement à la surface du substrat exposé à l'air et qui empêchent une bonne adhésion de la couche de protection 4.

Avantageusement, cette étape d) consiste en un prétraitement par plasma Ar ou plasma Ar/H₂.

Selon un mode de mise en oeuvre du procédé de l'invention, l'étape c) est mise en oeuvre directement après l'étape d), sans autre prétraitement complémentaire.

Avantageusement, le substrat argenté 1, 10 peut être traité thermiquement avant l'étape b) ou avant l'étape c) afin de relaxer d'éventuelles contraintes internes liées aux étapes d'usinage ou de dépôt de couches précédentes. Les températures et durées de traitements dépendent de la nature du substrat et des couches et ne doivent pas impacter l'esthétique de la pièce avant le dépôt de la couche de protection de l'étape c). Les paramètres de traitement thermiques sont connus de l'homme du métier et ne nécessitent pas ici de plus amples détails.

Selon un autre mode de mise en oeuvre, le procédé de l'invention comprend une étape intermédiaire e) complémentaire, entre l'étape d) et l'étape c), de prétraitement oxydant, permettant de créer des sites AgO/Ag₂O formant des liaisons covalentes entre les Al₂O₃ présents dans la première couche 4a et l'argent de la surface argentée finale du substrat de manière à favoriser l'adhésion de la couche de protection 4 sur le substrat.

Selon une variante, le prétraitement oxydant de l'étape e) peut consister en un prétraitement par plasma oxydant avec un agent oxydant tel que l'oxygène, ou Ar/O₂, permettant de créer les sites AgO/Ag₂O.

Le dosage de O₂ dans le plasma doit être précis afin de créer suffisamment de sites AgO/Ag₂O, mais qui ont tendance à jaunir l'argent, tout en garantissant la blancheur de l'argent.

Les paramètres de traitement par plasma sont connus de l'homme du métier et ne nécessitent pas ici de plus amples détails.

Selon une autre variante, le prétraitement oxydant de l'étape e) peut consister à injecter de l'eau ou du peroxyde d'hydrogène, liquide, dans une chambre de prétraitement sous vide provoquant la vaporisation de l'eau ou du peroxyde d'hydrogène, qui au contact du substrat, va former les sites AgO/Ag₂O. La quantité d'eau ou de peroxyde d'hydrogène injecté est de l'ordre de quelques dizaines de micromoles.

D'une manière particulièrement avantageuse, l'étape e) est réalisée sans mise à l'air entre l'étape d) et ladite étape e). A cet effet, le substrat prétraité selon l'étape d) subit le prétraitement complémentaire selon l'étape e) sans casser le vide.

De plus, le substrat issu de l'étape b) et prétraité selon l'étape d) uniquement ou selon les étapes d) et e) est ensuite avantageusement transféré sous vide dans une chambre de dépôt, de préférence par dépôt ALD, pour une mise en oeuvre directe de l'étape c) sur le substrat prétraité issu de l'étape d) ou des étapes d) et e), sans mise à l'air de la surface argentée finale du substrat.

A cet effet, les étapes d) et e) de prétraitement et l'étape c) de dépôt de la couche de protection, de préférence par dépôt ALD, sont avantageusement mises en oeuvre dans une même machine de traitement global dans laquelle le dispositif de prétraitement selon l'étape d) ou selon les étapes d) et e) est intégré au dispositif de dépôt de la couche de protection 4, de préférence par dépôt ALD, permettant un traitement global sans mise à l'air de la surface argentée finale du substrat, et de préférence sous vide, pour la mise en oeuvre des étapes d), éventuellement e) si présente, et c).

Un substrat comprenant une surface argentée finale, traité selon le procédé de l'invention, présente une couche de protection contre le ternissement de l'argent sans défaut d'adhérence. En outre, et en particulier lorsque la couche de protection contre le ternissement de l'argent a été déposée par ALD, l'effet très blanc de l'argent est préservé malgré la présence de la couche de protection contre le ternissement de l'argent. Si le substrat a été guilloché, les détails fins du guillochage restent nettement apparents malgré la présence de ladite couche de protection contre le ternissement de l'argent.

Les produits de bijouterie, d'instruments d'écriture, de lunetterie et de maroquinerie peuvent également être avantageusement traités par ce procédé.

## Revendications

1. Procédé pour améliorer l'adhérence d'une couche de protection contre le ternissement de l'argent sur un substrat comprenant une surface argentée finale, **caractérisé en ce qu'**il comprend les étapes suivantes :
a) se munir d'un substrat (1, 10) présentant ou non une surface argentée initiale
b) déposer sur ledit substrat (1, 10) de l'étape a) une couche (2) d'un alliage d'argent et de cuivre comprenant entre 0.1% et 10% en poids de cuivre par rapport au poids total de l'alliage pour obtenir ladite surface argentée finale
c) déposer sur au moins une partie de ladite surface argentée finale obtenue à l'étape b) au moins une couche (4) de protection contre le ternissement de l'argent présentant une épaisseur comprise entre 1 nm et 200 nm, préférentiellement entre 40 nm et 100 nm.

2. Procédé selon la revendication 1, **caractérisé en ce que**, lorsque le substrat (1) de l'étape a) comprend une surface argentée initiale, ledit substrat est à base d'argent et présente intrinsèquement ladite surface argentée initiale.

3. Procédé selon la revendication 1, **caractérisé en ce que**, lorsque le substrat (10) de l'étape a) comprend une surface argentée initiale, ledit substrat n'est pas à base d'argent et ladite surface argentée initiale est obtenue par un dépôt d'une couche (20) d'argent sensiblement pur sur ledit substrat.

4. Procédé selon la revendication 3, **caractérisé en ce que** la couche (20) d'argent sensiblement pur présente une épaisseur comprise entre 200 nm et 3 000 nm.

5. Procédé selon la revendication 4, **caractérisé en ce que** la couche (20) d'argent sensiblement pur présente une épaisseur comprise entre 200 nm et 600 nm, de préférence entre 300 nm et 500 nm.

6. Procédé selon la revendication 4, **caractérisé en ce que** la couche (20) d'argent sensiblement pur présente une épaisseur comprise entre 1 000 nm et 3 000 nm, de préférence entre 1 500 nm et 2 500 nm.

7. Procédé selon l'une des revendications précédentes, **caractérisé en ce que** la couche (2) d'alliage d'argent et de cuivre présente une épaisseur comprise entre 200 nm et 600 nm, de préférence entre 300 nm et 400 nm.

8. Procédé selon l'une des revendications précédentes, **caractérisé en ce que** l'alliage d'argent et de cuivre comprend entre 0.2% et 8% en poids, de préférence entre 0.5% et 7% en poids, de cuivre par rapport au poids total de l'alliage.

9. Procédé selon l'une des revendications précédentes, **caractérisé en ce que** l'on utilise pour réaliser la couche (4) de protection contre le ternissement de l'argent déposée à l'étape c) un oxyde métallique choisi parmi Al₂O₃, Ta₂O₅, HfO₂, ZnO, SiO₂ et TiO₂, ou un nitrure.

10. Procédé selon l'une des revendications précédentes, **caractérisé en ce que** l'étape c) comprend une étape c1) de dépôt sur au moins une partie de ladite surface argentée finale obtenue à l'étape b) d'une première couche (4a) de Al₂O₃ et une étape c2) de dépôt, sur la première couche (4a) de Al₂O₃ obtenue à l'étape c1), d'une seconde couche (4b) de TiO₂.

11. Procédé selon la revendication 10, **caractérisé en ce que** la première couche (4a) de Al₂O₃ présente une épaisseur comprise entre 0.5 nm et 100 nm et **en ce que** la seconde couche (4b) de TiO₂ présente une épaisseur comprise entre 0.5 nm et 100 nm.

12. Procédé selon la revendication 11, **caractérisé en ce que** la première couche (4a) de Al₂O₃ présente une épaisseur comprise entre 30 nm et 50 nm et **en ce que** la seconde couche (4b) de TiO₂ présente une épaisseur comprise entre 10 nm et 50 nm.

13. Procédé selon l'une des revendications précédentes, **caractérisé en ce que** l'étape c) est réalisée par une méthode choisie parmi le groupe comprenant un dépôt ALD, PVD, CVD, et sol-gel.

14. Procédé selon la revendication 13, **caractérisé en ce que** l'étape c) est réalisée par dépôt ALD.

15. Procédé selon l'une des revendications 10 à 14, **caractérisé en ce qu'**il comprend, avant et/ou après l'étape c2), une étape de traitement par plasma.

16. Procédé selon l'une des revendications précédentes, **caractérisé en ce qu'**il comprend, avant l'étape b) et/ou avant l'étape c), une étape de traitement thermique du substrat (1, 10) pour relaxer d'éventuelles contraintes internes dans ledit substrat (1, 10).

17. Procédé selon l'une des revendications précédentes, **caractérisé en ce qu'**il comprend, entre l'étape b) et l'étape c), au moins une étape d) de prétraitement par plasma de la surface argentée finale du substrat obtenu à l'étape b).

18. Procédé selon la revendication 17, **caractérisé en ce que** l'étape d) de prétraitement par plasma consiste en un prétraitement par plasma Ar ou plasma Ar/H2.

19. Procédé selon l'une des revendications 17 et 18, **caractérisé en ce que** l'étape c) est réalisée sans mise à l'air de la surface argentée finale du substrat entre l'étape d) et ladite étape c).

20. Procédé selon l'une des revendications 17 et 18, **caractérisé en ce qu'**il comprend, entre l'étape d) et l'étape c), une étape e) de prétraitement oxydant.

21. Procédé selon la revendication 20, **caractérisé en ce que** l'étape e) de prétraitement oxydant consiste en un prétraitement par plasma avec un agent oxydant.

22. Procédé selon la revendication 20, **caractérisé en ce que** l'étape e) de prétraitement oxydant consiste à injecter de l'eau ou du peroxyde d'hydrogène, liquide, dans une chambre de prétraitement sous vide.

23. Procédé selon les revendications 20 à 22, **caractérisé en ce que** l'étape e) est réalisée sans mise à l'air de la surface argentée finale du substrat entre l'étape d) et ladite étape e).

24. Procédé selon les revendications 20 à 23, **caractérisé en ce que** l'étape c) est réalisée sans mise à l'air de la surface argentée finale du substrat entre l'étape e) et ladite étape c).

25. Procédé selon la revendication 24, **caractérisé en ce que** les étapes d), e) et c) sont mises en oeuvre dans une même machine de traitement global.

26. Procédé selon l'une des revendications précédentes, **caractérisé en ce que** le substrat (1, 10) est un élément d'horlogerie.

27. Procédé selon la revendication 26, **caractérisé en ce qu'**on réalise sur la surface du substrat (1, 10) une structuration.

28. Procédé selon l'une des revendications précédentes, **caractérisé en ce que** le substrat (1, 10) est métallique, et de préférence à base d'or ou d'argent.

29. Utilisation d'une couche (2) d'un alliage d'argent et de cuivre comprenant entre 0.1% et 10% en poids de cuivre par rapport au poids total de l'alliage déposée sur un substrat (1, 10) présentant ou non une surface argentée initiale afin d'obtenir un substrat présentant une surface argentée finale, pour améliorer l'adhérence d'une couche (4) de protection contre le ternissement de l'argent déposée sur ladite surface argentée finale, ladite couche (4) de protection contre le ternissement de l'argent présentant une épaisseur comprise entre 1 nm et 200 nm, préférentiellement entre 40 nm et 100 nm.
